(19) Europäisches Patentamt

European Patent Office

Office européen des brevets

(11) **EP 1 376 871 A1**

(12) **EUROPEAN PATENT APPLICATION**

(43) Date of publication:
**02.01.2004 Bulletin 2004/01**

(51) Int Cl.$^7$: **H03K 17/96**

(21) Application number: **02023293.0**

(22) Date of filing: **17.10.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **SIEMENS AKTIENGESELLSCHAFT 80333 München (DE)**

(72) Inventors:
• **Hoeyer, Michael**
  **9200 Aalborg SV (DK)**
• **Nielsen, Thomas Gilbert**
  **9430 Vadum (DK)**

(54) **Input device and input method**

(57) A device for obtaining user input includes i) a source (11) for emitting acoustic waves, ii) a receiver (12) for detecting acoustic waves, such as a transducer, adapted to produce a signal (SIG) responsive to an acoustic wave detected, iii) modulation means (13) responsive to user input, adapted to modulate acoustic waves emitted, and iv) converting means (14) adapted to produce user input (INPUT) in response to the signal (SIG). Acoustic waves may be emitted in bursts, and the modulation may cause a reflection of the acoustic wave or it may change the frequency of the acoustic wave.

FIG 2

EP 1 376 871 A1

## Description

### Field of the invention

The invention relates generally to obtaining user input for an electronic device. More specifically, the invention relates to obtaining user input with an electroacoustic arrangement.

### Background of the invention

The still growing number of users of mobile terminals together with the high competition on the market set very high requirements for the design of mobile terminals. On one hand, the manufacturing process has to be easy and the assembling procedure with all components required has to be cost effective. On the other hand, consumers expect the new terminals to include lucrative and fascinating properties and to have an aesthetically pleasing design.

One of the components having a large impact on the consumers' decision whether or not to buy a specific device is the input mechanism such as the keyboard or dialling buttons of the mobile terminal. In most contemporary devices, such as mobile terminals, the keyboard is implemented using mechanic push buttons. The mechanic push buttons suffer from several problems. The mechanics may wear in use; it does not look appealing, and it is very challenging to construct a waterproof keyboard. The mechanical and electro-mechanical structure of the buttons in the keyboard also poses some severe restrictions for the designer for the placement of the buttons.

It is an object of the invention to bring about a novel input device and method both being easy and cost-effective to manufacture and having a reasonable size for use in a mobile terminal, and by using which it is possible to provide portable devices with a nice outlook. Another objective of the invention is to bring about a new input method possible, even reusing some hardware components already existing.

### Summary of the invention

This and other objectives of the invention can be achieved with a method and a system according to any one of the independent patent claims.

A device for obtaining user input, includes i) a source for emitting acoustic waves, ii) a receiver for detecting acoustic waves, such as a transducer, adapted to produce a signal responsive to an acoustic wave detected, iii) modulation means responsive to user input, adapted to modulate acoustic waves emitted, and iv) converting means adapted to produce user input in response to the signal. Such a device enables giving user input without any mechanical switches, and further, helps with the endeavours to construct a waterproof input device.

According to one aspect of the present invention, the source is adapted to emit acoustic waves in a burst. This helps in reducing energy consumption of the input device, which is especially useful if the device is employed in a mobile device, because as well known, the charge in the battery of the device gets easily a scarce resource.

According to a further aspect of the present invention, the source is adapted to emit acoustic waves on a frequency range above a normal human hearing limit. This helps in increasing the comfort of use, as the whole neighbourhood is not necessarily disturbed if one is giving user input using the device. Similarly, pet animals, such as dogs, do not get nervous.

According to a further aspect of the present invention, the device further includes a timer for measuring a time between a burst is emitted by the source and detected by the receiver; and wherein the converting means are adapted to derive the user input using the time measured. This aspect of the present invention enables the input device to be an object of a compressible type.

According to a further aspect of the present invention, the modulation means are adapted to modulate frequency of an acoustic wave; and the receiver and/or the converting means are adapted to produce the signal at least partially responsive to a frequency of the acoustic wave detected. This aspect of the present invention enables the input device to be an object of a flute -like type.

### Brief description of the drawings

In the following, the invention and its preferred embodiments are described more closely referring to the examples shown in Figures 1 to 4 in the appended drawings wherein

Figure 1    illustrates a first embodiment of the input device according to the invention,

Figure 2    illustrates a second embodiment of the input device according to the invention,

Figure 3    illustrates one possible mechanical structure for the acoustic wave conductor 15, and

Figure 4    illustrates the input device according to the invention installed in a mobile terminal.

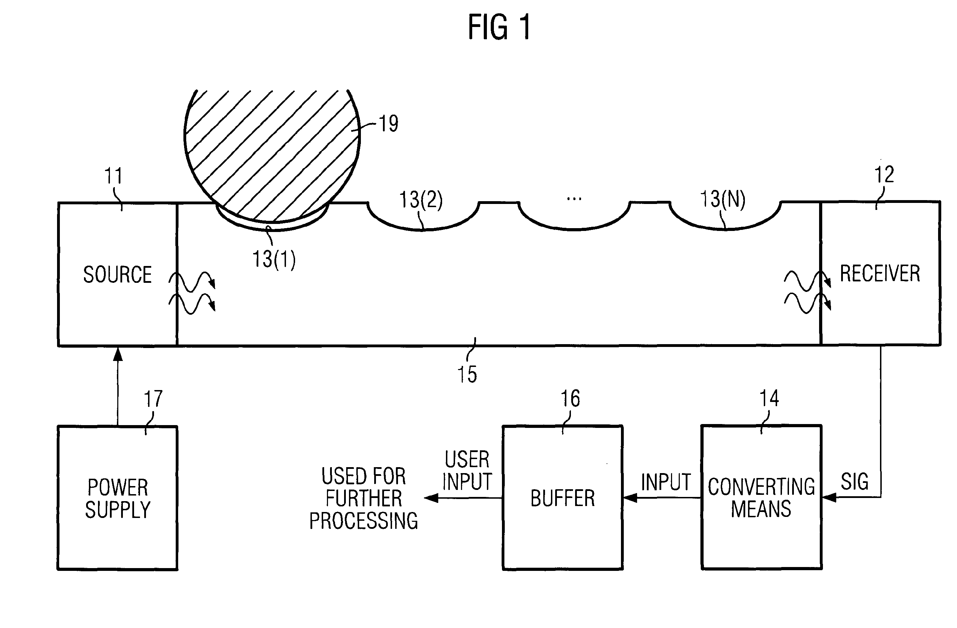

Like reference signs refer to corresponding parts and elements throughout Figures 1 to 4.

### Detailed description of the invention

Figure 1 illustrates a first embodiment of the input device according to a first embodiment of the present invention. Source 11, e.g. an electro-acoustic transducer, emits acoustic waves. The acoustic waves are carried in acoustic wave conductor 15 towards a receiver 12. The acoustic wave conducted in the acoustic wave conductor 15 may be modulated by modulating means 13.

Figure 1 shows that the modulation means 13 may comprise a sequence of modulation means 13(1), 13(2), ..., 13(N). The modulation means 13 may be activated by bringing a modulating object 19 into the vicinity of the modulation means 13.

The modulating object 19 changes the spectra of the acoustic waves detected at the receiver 12, e.g. a microphone or an acousto-electrical transducer. The modulation means 13 together with the acoustic wave conductor 15 may together be a flute like object, such as a tube penetrated with a number of holes corresponding to the number of buttons. The holes are covered with a thin woven fabric which is not air-proof but waterproof. If a modulating object 19, such as a finger of a user touches the modulation means 13 corresponding a hole, the spectra of the signal detected at the receiver 12 changes.

The receiver 12 sends a signal SIG to converting means 14. The converting means 14 are adapted with means to produce a user input INPUT in response to the signal SIG. The user input INPUT may be passed to a buffer 16 for storing the user input INPUT as an input string. The buffer 16 may then forward the stored input string to some other block of the device to be used for further processing.

Power is supplied to the source 11 by a power supply 16. To minimise the power consumption, it could be reasonable to hand a slow update ratio of the buttons when it is some time since the last touch. This means touching a button for about two seconds which changes the update frequency and enables a faster ration. By using an acoustic system for typing in data on a device more expensive mechanical or capacitance based systems can be replaced and also more appealing devices can be made. The power supply 16, such as a battery, can be used for supplying electrical energy to other system components as well, such as the converting means 14 and the buffer 16.

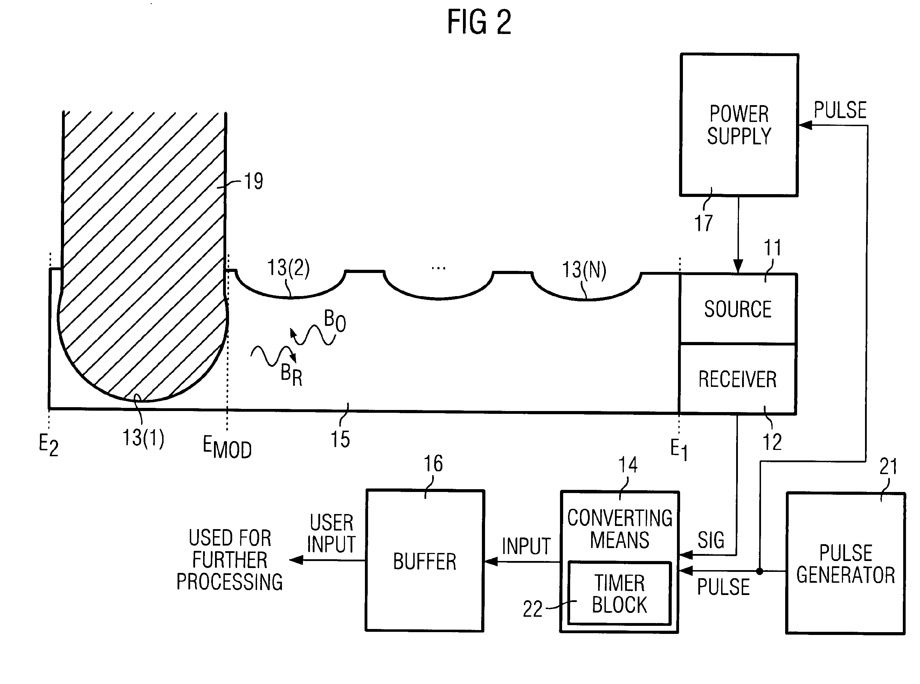

Figure 2 illustrates a second embodiment of the present invention. A burst $B_O$ of acoustic waves are emitted by a source 11. Acoustic waves are also received by a receiver 12 like in the first embodiment, but now as a reflected burst $B_R$ of acoustic waves. The modulation of the burst $B_O$ thus, in this embodiment of the present invention, corresponds to reflecting it. Hence, instead of primarily measuring the spectrum detected at the receiver 12, the user input is obtained by measuring the time $\Delta t = t_R - t_O$ ($t_R$ = moment of receiving; $t_O$ = moment of emitting the burst) needed from the acoustic waves emitted to pass the acoustic wave conductor 15 from the source 11, and to be reflected back to the receiver 12.

The time $\Delta t$ for a burst between it was emitted by source 11 and detected by receiver 12 depends whether a modulating object 19 is present, and if it is present, depending on its position in relation to the modulation means 13(1), 13(2),..., 13(N), according to the following equation

$$2l = c_{SND}\ \Delta t,$$

where $l$ represents the total length of the path for the acoustic wave ($l = x_R - x_O$, where $x_R$ = position of the reflector 13(i), and $x_O$ = position of the source 11), and $c_{SND}$ is the speed of sound (i.e. the speed of the acoustic wave) in the transporting medium inside the acoustic wave conductor 15. Usually the transporting medium inside the acoustic wave conductor 15 is air.

The acoustic burst reflects back from the modulation means 13 where the modulating object 19 is present, or from the modulating object 19 directly. The acoustic wave conductor 15 may be arranged to form at least part of the modulation means 13, such as by using an elastic material which has at some intervals 13(i) (where i=1, 2, ..., N) a thinner shell for obtaining better formability, and, correspondingly, for enabling the position 13(i) to act as sound reflector.

The source 11 sends a burst of acoustic waves through the acoustic wave conductor 15 which have a closed end E2. The receiver 12 is preferably located at the same end E1 of the acoustic wave conductor 15 as the source 11. The receiver 12 is listening to the signal close to the position of the source 11. The burst of acoustic waves detected by the receiver 12 and the lapsed time span $\Delta t$ between emission of the outgoing burst and detection of the reflected burst is a measure for the distance $l$, namely, $l = \frac{1}{2}\ c_{SND}\ \Delta t$. This distance or delay in time is used to determine which modulation means 13 were activated.

Simply, in the case where the source 11 and receiver 12 are located close to each other, such as in Figure 2, time $t_O$ for the outgoing burst $B_O$ is to a good approximation equal to time $t_R$ for the reflected burst $B_R$. Therefore, $t = 2 * c * l_{TUBE}$, where $l_{TUBE}$ = distance between the end $E_1$ and the position of the modulation means $E_{MOD}$. In other words, $2l = C_{SND}\ (t_R - t_O)$, from which follows that $l = \frac{1}{2}\ c_{SND}\ \Delta t$.

The pulsed bursts may be easily transmitted by periodically controlling the power supply 17 which is feeding the source 11, or, if the same power supply 17 is used to feed electric energy to other system components, then by periodically controlling the power line between power supply 17 and source 11. Such a controlling may be produced by a pulse generator 21 sending a pulse to the power supply 17 which after receiving the pulse transmits power to the source 11.

The pulse generator 21 sends a pulse to the converting means 14 as well. The converting means 14, after receiving a pulse, activate a timer block 22 which measures the time $t_{MEAS}$ between its activation and the time during which a signal SIG is obtained from the receiver 12. The distance $l_{TUBE}$ of the modulating object 19 from the source 11 can then easily be calculated if the distance between the receiver and the modulating object 19 is the same as the distance between the source 11 and the modulating object 19, just as disclosed above.

The distance of the modulating object 19 may thus be obtained by dividing half of the time delay between the pulse and the signal received at the converting means 14 by the speed of sound in the conducting medium inside the acoustic wave conductor 15. Also some delay-related parameters, such as the latence time of the receiver 12, or the response time of the power supply 17 to the pulse from the pulse generator 21, may be estimated and subtracted from the obtained time difference in order to enhance the performance of the device.

The system can be further simplified, if instead of computing the distances between source 11 and modulator 13(i) only the time $t_{MEAS}$ is used to characterise the user input. Because each of the modulating means 13(1), 13(2), ..., 13(N) is located at a separate distance from the source 11 and/or receiver 12, the $t_{MEAS}$ then, possibly provided with some tolerable error margins, can be used to give an input function to map $t_{MEAS}$ on a discrete input value.

The acoustic wave conducting means can be made of hard material so that the walls of the acoustic wave conductor 15 do not absorb the energy of the bursts emitted. One purpose is to get reflections from the end E2 or at the position $E_{MOD}$ of the modulation means 13, because as usually, waves are reflected when they meet the end wall of a closed tube. At those locations of the acoustic wave conductor 15 where modulation means 13(i) (i=1, 2, ..., N) are located, the tube is made of a silicon material that makes the user able to squeeze the modulation means 13 to cause a burst tobe at least partly reflected. In order to shorten the response time ie to get the modulation means 13 or the acoustic wave conductor 15 quicker back to their non-deformed state, a spring can be inserted in the acoustic wave conductor 15.

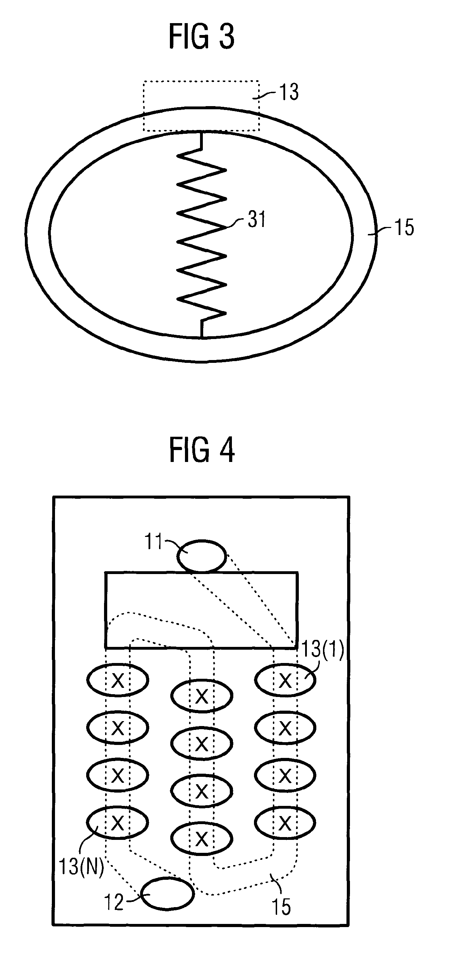

Figure 3 illustrates the latter kind of system where the modulating means 13 comprise a part of the acoustic wave conductor 15. In order to shorten the response time of the input device a spring 31 has been installed.

Figure 4 illustrates one possible use for the input device within a device wherein it is assembled. The acoustic wave conductor 15 can be made to comprise a part of a portion of the device. In this way, the input device can be produced as a process in an injection molding apparatus. Thereby, it saves cost as compared to assembling traditional mechanical buttons into the device. Depending on the environment, it may be reasonable to make the input device to reuse some existing components of the device. For example, as the source 11 an ordinary loudspeaker already included in mobile terminals, such as mobile phones, may be used, and as the receiver 12, microphone of the mobile terminal may be used. Such a construction needs then some acoustic sealing system to prohibit the sending of signal tones to the ear of the user. Instead of reusing a microphone, a receiver with a more specific characteristics can be used to make the system stable. Recent loudspeakers with high enough bandwidth for implementing the present invention are reasonably costly at the moment, so also a special transducer can be used for generating the signals.

One possible use for the method or device according to any one of the embodiments of the present invention relates to mobile terminals, such as mobile phones. The methods and devices can be used in order to obtain a number to be dialled; or to modify or select phonebook entries.

Although the invention was described above with reference to the examples shown in the appended drawings, it is obvious that the invention is not limited to these but may be modified by those skilled in the art without difference from a scope and spirit of the invention.

References

| | |
|---|---|
| 11 | source |
| 12 | receiver |
| 13 | modulation means |
| 14 | converting means |
| 15 | acoustic wave conductor |
| 16 | buffer |
| 17 | power supply |
| 19 | modulating object |
| 21 | pulse generator |
| 22 | timer block |
| 31 | spring |

**Claims**

1. A device for obtaining user input, the device
   **characterised in that**
   it includes:

   - a source (11) for emitting acoustic waves;
   - modulation means (13) responsive to user input, adapted to modulate acoustic waves emitted; and
   - a receiver (12) for detecting acoustic waves, such as a transducer, adapted to produce a signal (SIG) responsive to an acoustic wave detected;
   - converting means (14) adapted to produce user input (INPUT) in response to the signal (SIG).

**2.** A device according to claim 1, **wherein:** the source (11) is adapted to emit acoustic waves in a burst.

**3.** A device according to claim 1 or 2, **wherein:** the source (11) is adapted to emit acoustic waves on a frequency range above a normal human hearing limit.

**4.** A device according to claim 1, 2, or 3, **characterised in that** it further includes:

- a timer for measuring a time between a burst is emitted by the source (11) and detected by the receiver (12); and wherein:

- the converting means (14) are adapted to derive the user input using the time measured.

**5.** A device according to any one of the preceding claims, **characterised in that**

- the modulation means (13) are adapted to modulate frequency of an acoustic wave; and
- the receiver (12) and/or the converting means (14) are adapted to produce the signal (SIG) at least partially responsive to a frequency of the acoustic wave detected.

**6.** A device according to any one of the preceding claims, **characterised in that**

- the receiver (12) and/or the converting means (14) are adapted to produce the signal (SIG) at least partially responsive to a frequency change of the acoustic wave detected.

**7.** A device according to any one of the preceding claims, **characterised in that** the device further includes acoustic wave conducting means (15) arranged in connection to the modulation means (13).

**8.** A device according to any one of the preceding claims, **characterised in that** the device further includes a buffer (16) for storing the user input as an input string.

**9.** A device according to any one of the preceding claims, **wherein:** the device is used for obtaining user input on a mobile device, such as a mobile terminal.

**10.** A device according to any one of the preceding claims, **wherein:** the user input corresponds to a recipient address, such as a telephone number.

**11.** A method for obtaining user input, the method **characterised in that** it contains the steps of:

- emitting acoustic waves;
- modulating acoustic waves emitted;
- detecting acoustic waves, in which method step a signal (SIG) is produced; and
- producing user input (INPUT) in response to the signal (SIG).

**12.** A method according to claim 11, **wherein:** in the emitting step, acoustic waves are emitted in bursts.

**13.** A method according to claim 11 or 12, **wherein:** in the emitting step, acoustic waves are emitted in a frequency range above a normal human hearing limit.

**14.** A method according to any one of claims 11 to 13, **wherein:** in the modulating step a reflection responsive to the user input is be caused on the acoustic waves.

**15.** A method according to any one of claims 11 to 14, **wherein:** in the modulating step a frequency of the acoustic waves is changed.

**16.** A mobile phone **wherein:** a method or device according to any one of the preceding claims is used in order to obtain a number to be dialled; or to modify or select phonebook entries.

FIG 1

# FIG 2

EP 1 376 871 A1

# FIG 3

# FIG 4

**European Patent Office**

## EUROPEAN SEARCH REPORT

Application Number

EP 02 02 3293

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 599 607 A (HILL LAWRENCE R) 8 July 1986 (1986-07-08) * column 2, line 4 - column 4, line 16; figures * --- | 1-4, 7-14,16 | H03K17/96 |
| X | EP 0 675 600 A (WHITAKER CORP) 4 October 1995 (1995-10-04) * column 6, line 7 - column 7, line 11 * * column 8, line 53 - column 9, line 44; figures 1-4,9 * --- | 1,5-11, 13,14,16 | |
| X | US 6 236 339 B1 (KAMIZONO HIDENOBU) 22 May 2001 (2001-05-22) * column 3, line 1 - line 30; figures 1-3 * ----- | 1,5,11 | |
| | | | TECHNICAL FIELDS SEARCHED (Int.Cl.7) H03K |

The present search report has been drawn up for all claims

| Place of search | Date of completion of the search | Examiner |
|---|---|---|
| THE HAGUE | 14 April 2003 | D/L PINTA BALLE.., L |

EPO FORM 1503 03.82 (P04C01)

# EP 1 376 871 A1

**ANNEX TO THE EUROPEAN SEARCH REPORT
ON EUROPEAN PATENT APPLICATION NO.**                 EP 02 02 3293

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2003

| Patent document cited in search report | | Publication date | Patent family member(s) | | Publication date |
|---|---|---|---|---|---|
| US 4599607 | A | 08-07-1986 | NONE | | |
| EP 0675600 | A | 04-10-1995 | EP | 0675600 A1 | 04-10-1995 |
| | | | JP | 7282699 A | 27-10-1995 |
| | | | US | 5673041 A | 30-09-1997 |
| US 6236339 | B1 | 22-05-2001 | JP | 11265252 A | 28-09-1999 |

EPO FORM P0459

For more details about this annex : see Official Journal of the European Patent Office, No. 12/82

10